(19) Europäisches Patentamt
European Patent Office
Office européen des brevets

(11) **EP 4 658 017 A1**

(12) **EUROPEAN PATENT APPLICATION**

(43) Date of publication:
**03.12.2025 Bulletin 2025/49**

(21) Application number: **24222720.5**

(22) Date of filing: **23.12.2024**

(51) International Patent Classification (IPC):
**H10B 61/00** (2023.01)    **H10N 52/00** (2023.01)
**H10N 52/85** (2023.01)

(52) Cooperative Patent Classification (CPC):
**H10N 52/00; H10B 61/00; H10N 52/85**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **30.05.2024 KR 20240070873**
**30.07.2024 KR 20240100861**

(71) Applicant: **UIF (University Industry Foundation), Yonsei University**
**Seoul 03722 (KR)**

(72) Inventor: **HONG, Jongill**
**03722 Seoul (KR)**

(74) Representative: **Michalski Hüttermann & Partner Patentanwälte mbB**
**Kaistraße 16A**
**40221 Düsseldorf (DE)**

(54) **SEMICONDUCTOR DEVICE CAPABLE OF SIMULTANEOUSLY CHANGING POLARITY AND MAGNITUDE OF ANOMALOUS HALL EFFECT SIGNAL ACCORDING TO INPUT CURRENT, OPERATING METHOD THEREOF, AND SYSTEM**

(57)    A semiconductor device includes a free magnetization layer including a ferromagnetic layer and a nonmagnetic metal layer including current electrodes receiving an input current and Hall voltage electrodes outputting a Hall voltage. The Hall voltage is generated by an anomalous Hall effect occurring in the ferromagnetic layer of the free magnetization layer due to the input current flowing in the nonmagnetic metal layer. The Hall voltage has one of a local minimum value and a local maximum value when a value of the input current sequentially changes from a first value to a second value. One of the first value and the second value is greater than the other one of the first value and the second value.

FIG. 4B

EP 4 658 017 A1

**Description**

CROSS-REFERENCE TO RELATED APPLICATION

This application claims the benefit of Korean Patent Application No. 10-2024-0070873, filed on May 30, 2024, and No. 10-2024-0100861, filed on July 30, 2024, in the Korean Intellectual Property Office, the disclosure of which is incorporated herein in its entirety by reference.

BACKGROUND

The inventive concept relates to a semiconductor device, and more particularly, to a semiconductor device capable of simultaneously changing the polarity and magnitude of an anomalous Hall effect (AHE) signal according to an input current and a magnetization direction, an operating method of the semiconductor device, and a semiconductor system including the semiconductor device.

A Hall effect is a phenomenon in which a voltage is generated in a direction perpendicular to both the direction of a current and the direction of a magnetic field when the magnetic field is vertically applied to a conductor or a semiconductor from the outside while the current is flowing in the conductor or the semiconductor. The voltage generated at this time is called a Hall voltage.

A Hall effect occurs because charges (mainly electrons) related to the flow of a current are biased to one side within a conductor due to the force of a magnetic field. The force acting at this time is called the Lorentz force, which arises from the interaction between a magnetic field and a current. The direction of the Lorentz force is perpendicular to each of the direction of a current and the direction of a magnetic field.

An AHE occurs mainly in magnetic materials. While a Hall voltage is generated by an external magnetic field when a current flows in a conductor or a semiconductor in a normal Hall effect, a Hall voltage is generated by the magnetization of a magnetic material itself in an AHE.

SUMMARY

The inventive concept provides a semiconductor device capable of simultaneously changing the polarity and magnitude of an anomalous Hall effect (AHE) signal according to the combination of the value of an input current and a magnetization direction, an operating method of the semiconductor device, and a semiconductor system including the semiconductor device.

The inventive concept also provides a semiconductor device capable of simultaneously changing the polarity and magnitude of an AHE signal according to a controlled value of an input current, an operating method of the semiconductor device, and a semiconductor system including the semiconductor device.

According to an aspect of the inventive concept, there is provided a semiconductor device including a free magnetization layer including a ferromagnetic layer and a nonmagnetic metal layer including current electrodes receiving an input current and Hall voltage electrodes outputting a Hall voltage, wherein the Hall voltage is generated by an AHE occurring in the ferromagnetic layer of the free magnetization layer due to the input current flowing in the nonmagnetic metal layer, the Hall voltage has one of a local minimum value and a local maximum value when a value of the input current sequentially changes from a first value to a second value, and one of the first value and the second value is greater than the other one of the first value and the second value.

According to another aspect of the inventive concept, there is provided a semiconductor system including a semiconductor device including a free magnetization layer including a ferromagnetic layer and a nonmagnetic metal layer including current electrodes and Hall voltage electrodes, an input current control circuit configured to provide an input current to the current electrodes, the input current being controlled in response to a current control signal, and a Hall voltage detection circuit connected to the Hall voltage electrodes and configured to detect a Hall voltage generated by an AHE occurring in the ferromagnetic layer of the free magnetization layer due to the input current flowing in the nonmagnetic metal layer, wherein the Hall voltage has one of a local minimum value and a local maximum value when a value of the input current sequentially changes from a first value to a second value, and one of the first value and the second value is greater than the other one of the first value and the second value.

According to embodiments, when the value of the input current sequentially increases from the first value to a threshold current value, the Hall voltage may sequentially decrease and have the local minimum value at the threshold current value, and, when the value of the input current sequentially increases from a value greater than the threshold current value to the second value, the Hall voltage may sequentially increase.

According to embodiments, when the value of the input current sequentially decreases from the first value to a threshold current value, the Hall voltage may sequentially increase and have the local maximum value at the threshold current value, and, when the value of the input current sequentially decreases from a value less than the threshold current value to the second value, the Hall voltage may sequentially decrease.

According to a further aspect of the inventive concept, there is provided an operating method of a semiconductor device including a free magnetization layer including a ferromagnetic layer and a nonmagnetic metal layer. The operating method includes supplying an input current having a first value to the nonmagnetic metal layer, detecting a first Hall voltage generated by an AHE occurring in the ferromagnetic layer due to the input current that flows in the nonmagnetic metal layer and has the first value, supplying the input current having a second value to the nonmagnetic metal layer, and detecting a second Hall voltage generated by the AHE occurring in the ferromagnetic layer due to the input current that flows in the nonmagnetic metal layer and has the second value.

BRIEF DESCRIPTION OF THE DRAWINGS

Embodiments of the inventive concept will be more clearly understood from the following detailed description taken in conjunction with the accompanying drawings in which:

FIG. 1 illustrates a semiconductor system including a semiconductor device, according to an embodiment of the inventive concept;

FIG. 2 is a cross-sectional view of the semiconductor device of FIG. 1, taken along line A-A;

FIG. 3 illustrates the hysteresis loop of Hall resistivity with respect to the change of direct current (DC) current density supplied to a semiconductor device according to the related art;

FIG. 4A illustrates the hysteresis loops of Hall resistivity or Hall voltage, of which both the polarity and value simultaneously change according to a change in DC current density supplied to the semiconductor device of FIG. 1;

FIG. 4B is a graph showing the relationship between an input current and a Hall voltage, which are supplied to the semiconductor device of FIG. 1;

FIG. 4C is a flowchart of an operating method of the semiconductor device of FIG. 1 when the magnetization direction of the semiconductor device is a first magnetization direction;

FIG. 4D is a flowchart of an operating method of the semiconductor device of FIG. 1 when the magnetization direction of the semiconductor device is a second magnetization direction;

FIG. 5 is a graph showing a change in Hall resistivity or Hall voltage with respect to a change in the value of an input current supplied to the semiconductor device of FIG. 1 when the magnetization direction of the semiconductor device is a first magnetization direction;

FIG. 6 is a graph showing a change in an input current of the semiconductor device of FIG. 1 with respect to time;

FIG. 7 is a graph showing a change in Hall resistivity or Hall voltage with respect to a change in the magnetization direction of the semiconductor device of FIG. 1 and a change in the value of an input current supplied to the semiconductor device;

FIG. 8 is a graph showing a change in Hall resistivity or Hall voltage with respect to a change in the value of an input current supplied to the semiconductor device of FIG. 1 when the magnetization direction of the semiconductor device is a second magnetization direction; and

FIG. 9 is a graph showing a change in Hall resistivity or Hall voltage with respect to a change in the value of an input current supplied to the semiconductor device of FIG. 1 when the magnetization direction of the semiconductor device is a first magnetization direction.

DETAILED DESCRIPTION OF THE EMBODIMENTS

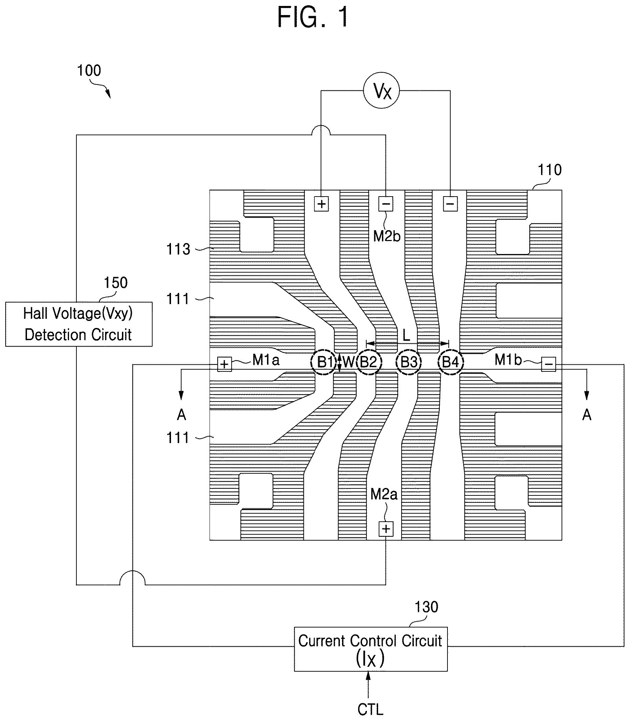

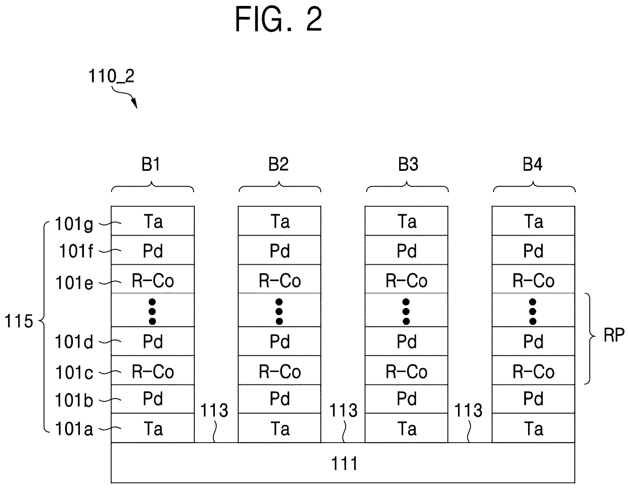

FIG. 1 illustrates a semiconductor system including a semiconductor device, according to an embodiment of the inventive concept. FIG. 2 is a cross-sectional view of the semiconductor device of FIG. 1, taken along line A-A.

Referring to FIGS. 1 and 2, a semiconductor system 100 may include a semiconductor device (or a memory device) 110, an input current control circuit 130, and a Hall voltage detection circuit 150.

The semiconductor system 100 may refer to a semiconductor integrated circuit, a system-on-chip (SoC), or a processor.

The semiconductor device 110 may include a free magnetization layer (or a magnetic free layer) 115 including ferromagnetic layer and a nonmagnetic metal layer 111, which is on the free magnetization layer 115 and includes current electrodes M1a and M1b and Hall voltage electrodes M2a and M2b.

For example, the ferromagnetic layer of the semiconductor device 110 may include a plurality of reduced cobalt layers 101c, but the inventive concept is not limited thereto. The nonmagnetic metal layer 111 may include metal, e.g., gold, copper, or aluminum. The reduced cobalt layers 101c may be separated from each other by a palladium layer 101d.

Referring to a cross-section 110_2 of FIG. 2, the free magnetization layer 115 may include tantalum (Ta) layer 101a, a palladium (Pd) layer 101b, repeated layers RP in which a reduced cobalt (R-Co) layer 101c and a Pd layer 101d are stacked at least twice, a reduced cobalt (R-Co) layer 101e, a Pd layer 101f, and a Ta layer 101g. Cobalt and reduced cobalt are ferromagnetic. Here, the Ta layer 101a is an example of a nonmagnetic material, and the inventive concept is not limited thereto. For example, two layers 101f and 101g may be replaced with material constituting the tunnel barrier layer of the Magnetic Tunnel Junction (MTJ), such as tunnel insulators, e.g., magnesium oxide (MgO).

For example, the thickness of the Ta layer 101a may be 4 nm, the thickness of the Pd layer 101b may be 3 nm, the thickness of the R-Co layer 101c may be 0.4 nm, the thickness of the Pd layer 101d may be 1 nm, the thickness of the Pd layer 101f may be 2 nm, and the thickness of the Ta layer 101g may be 3 nm. For example, reference numeral 113 denotes a portion etched by an etching process.

The input current control circuit 130 may provide an input current Ix, the value of which is adjusted by a current control signal CTL, to the nonmagnetic metal layer 111 through the current electrode M1a (or M1b). Here, the value may refer to a magnitude, amplitude, or a level.

The Hall voltage detection circuit 150 may detect a Hall voltage Vxy, which is generated by an anomalous Hall effect (AHE) occurring in one or more ferromagnetic layers of the free magnetization layer 115 according to the value of the input current Ix input into the the current electrode M1a (or M1b), through the Hall voltage electrodes M2a and M2b. For example, the input current Ix input to the current electrode M1a is output to the current electrode M1b through one or more layers 101a to 101f. For example, the input current Ix input to the current electrode M1b is output to the current electrode M1a through one or more layers 101a to 101f.

According to embodiments, the polarity and the value of the Hall voltage Vxy detected by the Hall voltage detection circuit 150 may be determined according to the value of the input current Ix.

Referring to FIG. 1, longitudinal resistivity, $\rho_{xx}$, may be defined as Equation 1:

$$\rho_{xx} = \frac{V_x}{I_x} \quad \frac{W}{L} \quad t \quad , \tag{1}$$

where $V_x$ is a voltage in the x-axis direction and determined according to the input current $I_x$, reference width W (e.g., 5 μm) and reference length L (e.g., 26 μm) are defined in FIG. 1, and t is the thickness of the nonmagnetic metal layer 111.

Transverse resistivity, i.e., Hall resistivity, $\rho_{xy}$, may be defined as Equation 2:

$$\rho_{xy} = \frac{V_{xy}}{I_x} \times t \tag{2}$$

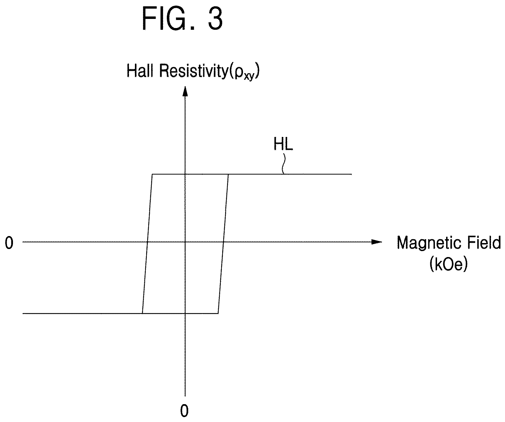

FIG. 3 illustrates the hysteresis loop of Hall resistivity with respect to a change in direct current (DC) current density supplied to a semiconductor device according to the related art. Although DC current density is described herein as an example of an input current, the inventive concept is not limited thereto. The input current may be in a pulse form or other forms.

Referring to FIGS. 2 and 3, the structure of a semiconductor device according to the related art may be different from the structure of a semiconductor device having the cross-section 110_2 of FIG. 2.

For example, as illustrated in FIG. 3, even when DC current density sequentially (i.e., continuously or discontinuously) changes from first DC current density (e.g., 0.8 MA/cm²) to second DC current density (e.g., 6.9 MA/cm²), a hysteresis loop HL of Hall resistivity, $\rho_{xy}$, hardly changes with respect to a change in a magnetic field applied to the semiconductor device according to the related art. For example, the x-axis represents the strength of the external magnetic field, and its unit is kilo-Oersted (kOe) and the y-axis represents the Hall resistivity.

In other words, even when an input current corresponding to DC current density applied to the semiconductor device according to the related art sequentially changes, the hysteresis loop HL of the Hall resistivity, $\rho_{xy}$, hardly changes with respect to a change in the external magnetic field kOe.

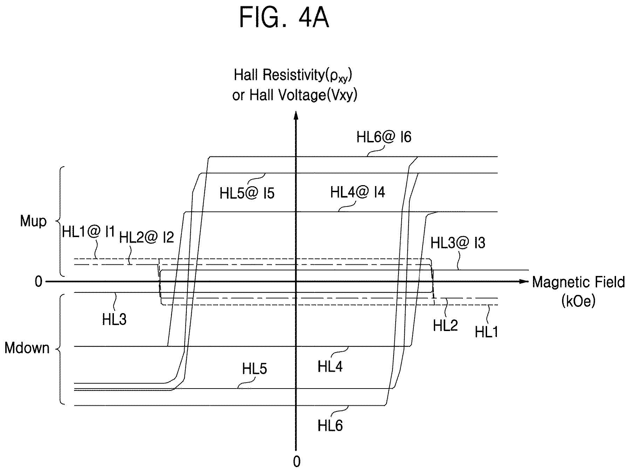

FIG. 4A illustrates the hysteresis loops of Hall resistivity or Hall voltage, of which both polarity and value simultaneously change according to a change in DC current density supplied to the semiconductor device of FIG. 1. Referring to FIG. 4A, the semiconductor device 110 shows different hysteresis loops HL1 to HL6 at values (e.g., I1 to I6) of the input current Ix. For example, in FIG. 4A, the x-axis represents the strength of the external magnetic field, and its unit is kilo-Oersted (kOe) and the y-axis represents the Hall resistivity or Hall voltage. Referring to Fig. 4A, the hysteresis loops HL1 to HL6 are changed with the variation (or changing) of the current Ix or voltage as a function of the external magnetic field. According to Fig. 4A, near the region where the external magnetic field is zero or within a range of coercive force, the maximum and minimum values of the hysteresis loops HL1 to HL6 are changed with the variation (or changing) of the current Ix or voltage. However, when the external magnetic field is zero or within a range of coercive force, in a typical ferromagnetic material, the maximum and minimum values do not change with the amplitude or magnitude of the current or voltage. In fact, referring to Fig. 3, the value of the anomalous Hall effect (AHE) does not change near the region where the external magnetic field is zero.

Referring to FIGS. 1, 2, and 4A, while a first current value I1 corresponding to first DC current density (e.g., 0.87 MA/cm$^2$) is being supplied to the nonmagnetic metal layer 111 through the current electrode M1a, the Hall resistivity, $\rho_{xy}$, at the first current value I1 may change from positive to negative when a magnetic field increases from negative to positive. HL1 denotes a first hysteresis loop with respect to the Hall resistivity, $\rho_{xy}$, at the first current value I1.

While a second current value I2 corresponding to second DC current density (e.g., 3.5 MA/cm$^2$) is being supplied to the nonmagnetic metal layer 111 through the current electrode M1a, the Hall resistivity, $\rho_{xy}$, at the second current value I2 may change from positive to negative when a magnetic field increases from negative to positive. HL2 denotes a second hysteresis loop with respect to the Hall resistivity, $\rho_{xy}$, at the second current value I2.

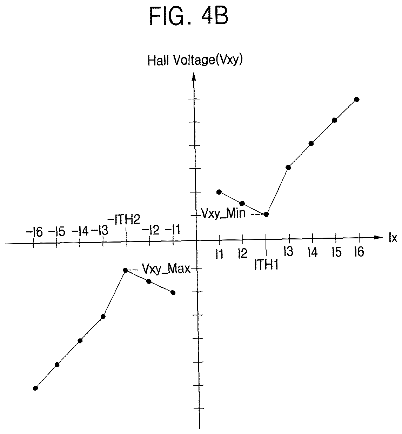

However, while a third current value I3 corresponding to third DC current density (e.g., 4.4 MA/cm$^2$) that is greater than a first threshold current value IHT1 (in FIG. 4B) is being supplied to the nonmagnetic metal layer 111 through the current electrode M1a, the Hall resistivity, $\rho_{xy}$, at the third current value I3 may change from negative to positive when a magnetic field increases from negative to positive. HL3 denotes a third hysteresis loop with respect to the Hall resistivity, $\rho_{xy}$, at the third current value I3.

While a fourth current value I4 corresponding to fourth DC current density (e.g., 7.0 MA/cm$^2$) is being supplied to the nonmagnetic metal layer 111 through the current electrode M1a, the Hall resistivity, $\rho_{xy}$, at the fourth current value I4 may change from negative to positive when a magnetic field increases from negative to positive. HL4 denotes a fourth hysteresis loop with respect to the Hall resistivity, $\rho_{xy}$, at the fourth current value I4.

While a fifth current value I5 corresponding to fifth DC current density (e.g., 7.8 MA/cm$^2$) is being supplied to the nonmagnetic metal layer 111 through the current electrode M1a, the Hall resistivity, $\rho_{xy}$, at the fifth current value I5 may change from negative to positive when a magnetic field increases from negative to positive. HL5 denotes a fifth hysteresis loop with respect to the Hall resistivity, $\rho_{xy}$, at the fifth current value I5.

While a sixth current value I6 corresponding to sixth DC current density (e.g., 10.0 MA/cm$^2$) is being supplied to the nonmagnetic metal layer 111 through the current electrode M1a, the Hall resistivity, $\rho_{xy}$, at the sixth current value I6 may change from negative to positive when a magnetic field increases from negative to positive. HL6 denotes a sixth hysteresis loop with respect to the Hall resistivity, $\rho_{xy}$, at the sixth current value I6. Here, the DC current density values, 0.87 MA/cm$^2$, 3.5 MA/cm$^2$, 4.4 MA/cm$^2$, 7.0 MA/cm$^2$, 7.8 MA/cm$^2$, and 10.0 MA/cm$^2$, are just examples for convenience of description.

FIG. 4B is a graph showing the relationship between an input current and a Hall voltage, which are supplied to the semiconductor device of FIG. 1.

Referring to FIGS. 4A and 4B, when theres is no external magnetic field (or near the region where the external magnetic field is zero) and the value of the input current Ix corresponding to DC current density supplied to the semiconductor device 110 sequentially increases from zero to the first threshold current value IHT1, the maximum value of the Hall resistivity, $\rho_{xy}$, of hysteresis loops (e.g., HL1 and HL2) may decrease. Thereafter, when the value of the input current Ix corresponding to the DC current density supplied to the semiconductor device 110 sequentially increases from a value greater than the first threshold current value IHT1 to the sixth current value I6, the maximum value of the Hall resistivity, $\rho_{xy}$, of a hysteresis loops (e.g., HL4, HL5, and HL6) may increase.

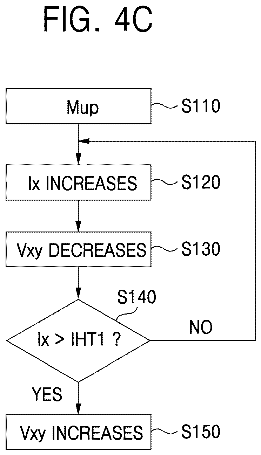

FIG. 4C is a flowchart of an operating method of the semiconductor device of FIG. 1 when the magnetization direction of the semiconductor device is a first magnetization direction.

Referring to FIGS. 4A to 4C, the values of the input current Ix are assumed to be I1<I2<ITH1<I3<I4<I5<I6. For example, DC current density values respectively corresponding to the values (e.g., I1 to I6) of the input current Ix may be 0.87 MA/cm$^2$, 3.5 MA/cm$^2$, 4.4 MA/cm$^2$, 7.0 MA/cm$^2$, 7.8 MA/cm$^2$, and 10.0 MA/cm$^2$, respectively.

The magnetization direction of the semiconductor device 110 may be assumed to be a first magnetization direction Mup (step S110). The first magnetization direction Mup may be opposite to a second magnetization direction Mdown, but the inventive concept is not limited thereto.

When the value of the input current Ix supplied to the semiconductor device 110 sequentially increases, for example, from a first value I1 to the first threshold current value ITH1, according to the current control signal CTL (step S120), the Hall resistivity, $\rho_{xy}$, or the Hall voltage Vxy may sequentially decrease (step S130). The Hall voltage Vxy may be referred to as an AHE signal.

In other words, until the value of the input current Ix supplied to the semiconductor device 110 is equal to the first threshold current value ITH1 (in case of NO in step S140), the Hall resistivity, $\rho_{xy}$, or the Hall voltage Vxy may decrease (step S130).

However, when the value of the input current Ix supplied to the semiconductor device 110 exceeds the first threshold current value ITH1 (in case of YES in step S140), the Hall resistivity, $\rho_{xy}$, or the Hall voltage Vxy may increase (step S150). At this time, it is assumed that the first threshold current value ITH1 is greater than a second value I2 and less than a third value I3.

For example, when the value of the input current Ix supplied to the semiconductor device 110 increases from the first threshold current value ITH1 to one of a plurality of values (e.g., I3, I4, I5, and I6) according to the current control signal CTL, the Hall resistivity, $\rho_{xy}$, or the Hall voltage Vxy may increase (step S150).

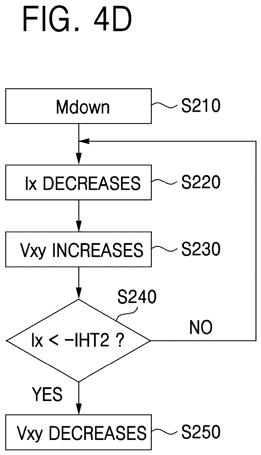

FIG. 4D is a flowchart of an operating method of the semiconductor device of FIG. 1 when the magnetization direction of the semiconductor device is a second magnetization direction.

Referring to FIGS. 4A, 4B, and 4D, the values of the input current Ix are assumed to be -I1>-I2>-ITH2>-I3>-I4>-I5>-I6. For example, DC current density values respectively corresponding to first to sixth values -I1 to -I6 may be -0.87 MA/cm$^2$, -3.5 MA/cm$^2$, -4.4 MA/cm$^2$, -7.0 MA/cm$^2$, -7.8 MA/cm$^2$, and -10.0 MA/cm$^2$, respectively.

Assuming that the value of the input current Ix when the magnetization direction of the semiconductor device 110 is the first magnetization direction Mup is positive, the value of the input current Ix when the magnetization direction of the semiconductor device 110 is the second magnetization direction Mdown may be defined to be negative. In other words, according to the magnetization direction of the semiconductor device 110, the sign of the input current Ix may be defined to be positive or negative although the absolute values of the input current Ix are the same.

The magnetization direction of the semiconductor device 110 may be assumed to be the second magnetization direction Mdown (step S210). When theres is no external magnetic field (or near the region where the external magnetic field is zero) and the value of the input current Ix supplied to the semiconductor device 110 sequentially decreases, for example, from the first value -I1 to a second threshold current value -ITH2, according to the current control signal CTL (step S220), the Hall resistivity, $\rho_{xy}$, or the Hall voltage Vxy may increase (step S230).

Until the value of the input current Ix supplied to the semiconductor device 110 is equal to the second threshold current value -ITH2 (in case of NO in step S240), the Hall resistivity, $\rho_{xy}$, or the Hall voltage Vxy may increase (step S230).

However, when the value of the input current Ix supplied to the semiconductor device 110 is less than the second threshold current value -ITH2 (in case of YES in step S240), the Hall resistivity, $\rho_{xy}$, or the Hall voltage Vxy may decrease (step S250). At this time, it is assumed that the second threshold current value -ITH2 is greater than the third value -I3 and less than the second value -I2.

When the Hall voltage Vxy is a function of the input current Ix, the first threshold current value ITH1 may be a local minimum (or inflection point) with respect to a minimum Hall voltage (or a minimum value) Vxy_Min, and the second threshold current value -ITH2 may be a local maximum (or inflection point) with respect to a maximum Hall voltage (or a maximum value) Vxy_Max. For example, the absolute value of the first threshold current value ITH1 may be the same as or different from the absolute value of the second threshold current value -ITH2.

For example, when the value of the input current Ix supplied to the semiconductor device 110 decreases from the second threshold current value -ITH2 to one of a plurality of values (e.g., -I3, -I4, -I5, and -I6) according to the current control signal CTL, the Hall resistivity, $\rho_{xy}$, or the Hall voltage Vxy may decrease (step S250). Here, the current values (e.g., -I1, -I2, -ITH2, -I3, -I4, -I5, and -I6) are conceptually set for convenience of description.

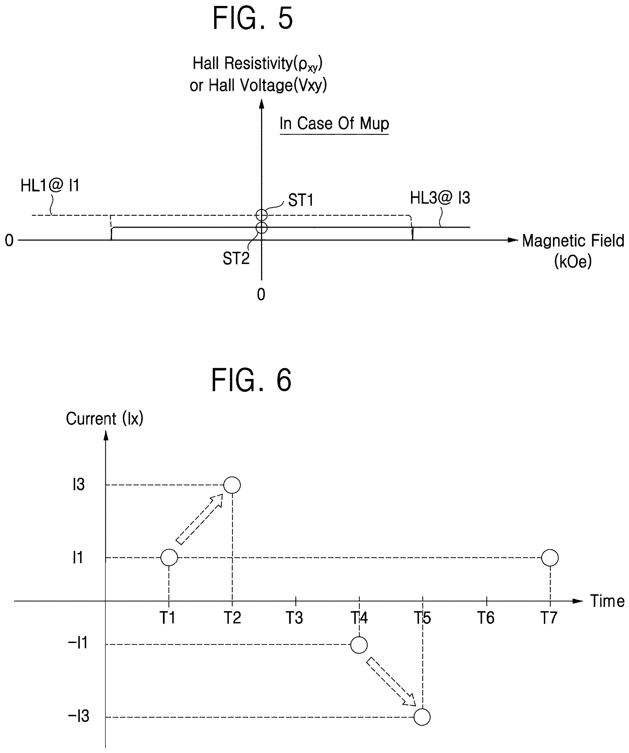

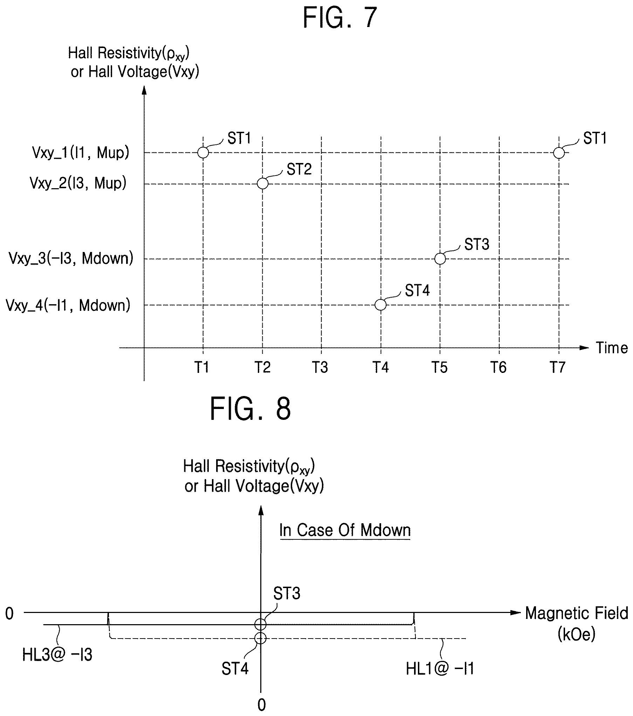

FIG. 5 is a graph showing a change in Hall resistivity or Hall voltage with respect to a change in the value of an input current supplied to the semiconductor device of FIG. 1 when the magnetization direction of the semiconductor device is a first magnetization direction. FIG. 6 is a graph showing a change in an input current of the semiconductor device of FIG. 1 with respect to time. FIG. 7 is a graph showing a change in Hall resistivity or Hall voltage with respect to a change in the magnetization direction of the semiconductor device of FIG. 1 and a change in the value of an input current supplied to the semiconductor device. FIG. 8 is a graph showing a change in Hall resistivity or Hall voltage with respect to a change in the value of an input current supplied to the semiconductor device of FIG. 1 when the magnetization direction of the semiconductor device is a second magnetization direction.

Referring to FIGS. 1, 2, and 4A to 5, it is assumed that the magnetization direction of the semiconductor device 110 is the first magnetization direction Mup. The first value I1 of the input current Ix may be less than the third value I3 of the input current Ix.

When the magnetization direction of the semiconductor device 110 is the first magnetization direction Mup, the input current Ix having the first value I1 may be supplied to the nonmagnetic metal layer 111 through the current electrode M1a at a first time point T1.

The Hall voltage detection circuit 150 may detect a first Hall voltage Vxy_1, which is generated by an AHE occurring in the ferromagnetic layer of the free magnetization layer 115 according to the first value I1 of the input current Ix input to the nonmagnetic metal layer 111 or the input current electrode M1a (or M1b), through the Hall voltage electrodes M2a and M2b. At this time, the state of the semiconductor device 110 may be defined as a first state ST1. At a second time point T2, the input current Ix having the third value I3 may be supplied to the nonmagnetic metal layer 111 through the current electrode M1a (or M1b).

The Hall voltage detection circuit 150 may detect a second Hall voltage Vxy_2, which is generated by an AHE occurring in the ferromagnetic layer of the free magnetization layer 115 according to the third value I3 of the input current Ix input to the nonmagnetic metal layer 111 or the input current electrode M1a (or M1b), through the Hall voltage electrodes M2a and M2b. At this time, the state of the semiconductor device 110 may change from the first state ST1 to a second state ST2.

When the magnetization direction of the semiconductor device 110 is the first magnetization direction Mup, both the Hall resistivity, $\rho_{xy}$, and the Hall voltage Vxy may decrease as the input current Ix increases from the first value I1 to the third value I3.

At a third time point T3, the magnetization direction of the semiconductor device 110 may change from the first magnetization direction Mup to the second magnetization direction Mdown. Because the input current Ix is zero at the third time point T3, the Hall voltage Vxy detected by the Hall voltage detection circuit 150 may also be zero.

According to embodiments, the magnetization direction of the semiconductor device 110 may change from the first magnetization direction Mup to the second magnetization direction Mdown, according to the value of the input current Ix or an external magnetic field of the semiconductor device 110.

After the magnetization direction of the semiconductor device 110 changes from the first magnetization direction Mup to the second magnetization direction Mdown, the input current Ix having a third value -I1 may be supplied to the nonmagnetic metal layer 111 through the current electrode M1a (or M1b) at a fourth time point T4.

The Hall voltage detection circuit 150 may detect a fourth Hall voltage Vxy_4, which is generated by an AHE occurring in the ferromagnetic layer of the free magnetization layer 115 according to the third value -I1 of the input current Ix input to the nonmagnetic metal layer 111 or the input current elcetrode M1a (or M1b), through the Hall voltage electrodes M2a and M2b. At this time, the state of the semiconductor device 110 may be defined as a fourth state ST4.

At a fifth time point T5, the input current Ix having a fourth value -I3 may be supplied to the nonmagnetic metal layer 111 through the current electrode M1a (or M1b). The fourth value -I3 of the input current Ix may be less than the third value -I1.

The Hall voltage detection circuit 150 may detect a third Hall voltage Vxy_3, which is generated by an AHE occurring in the ferromagnetic layer of the free magnetization layer 115 according to the fourth value -I3 of the input current Ix input to the nonmagnetic metal layer 111 or the input current electrode M1a(or M1b), through the Hall voltage electrodes M2a and M2b. At this time, the state of the semiconductor device 110 may change from the fourth state ST4 into a third state ST3.

When the magnetization direction of the semiconductor device 110 is the second magnetization direction Mdown, both the Hall resistivity, $\rho_{xy}$, and the Hall voltage Vxy may increase as the input current Ix decreases from the third value -I1 to the fourth value -I3.

At a sixth time point T6, the magnetization direction of the semiconductor device 110 may change from the second magnetization direction Mdown to the first magnetization direction Mup.

According to embodiments, the magnetization direction of the semiconductor device 110 may change from the second magnetization direction Mdown to the first magnetization direction Mup, according to the value of the input current Ix or an external magnetic field of the semiconductor device 110.

Because the input current Ix is zero at the sixth time point T6, the Hall voltage Vxy detected by the Hall voltage detection circuit 150 may also be zero.

After the magnetization direction of the semiconductor device 110 changes from the second magnetization direction Mdown to the first magnetization direction Mup, the input current Ix having the first value I1 may be supplied to the nonmagnetic metal layer 111 through the current electrode M1a (or M1b) at a seventh time point T7.

The Hall voltage detection circuit 150 may detect the first Hall voltage Vxy_1, which is generated by an AHE occurring in the ferromagnetic layer of the free magnetization layer 115 according to the first value I1 of the input current Ix input to the nonmagnetic metal layer 111 or the input current electrode M1a (M1b), through the Hall voltage electrodes M2a and M2b. At this time, the state of the semiconductor device 110 may be redefined as the first state ST1.

As described with reference to FIGS. 5 to 8, the polarity and the value of the Hall voltage Vxy of the semiconductor device 110 may be simultaneously determined according to both the magnetization direction of the semiconductor device 110 and the value of the input current Ix. Accordingly, the semiconductor device 110 may be in one state among the first to fourth states ST1 to ST4 each corresponding to "k" bits (where "k" is a natural number of at least 2, for example, when "k" is 2, "k" bits may be 00, 01, 11, or 10).

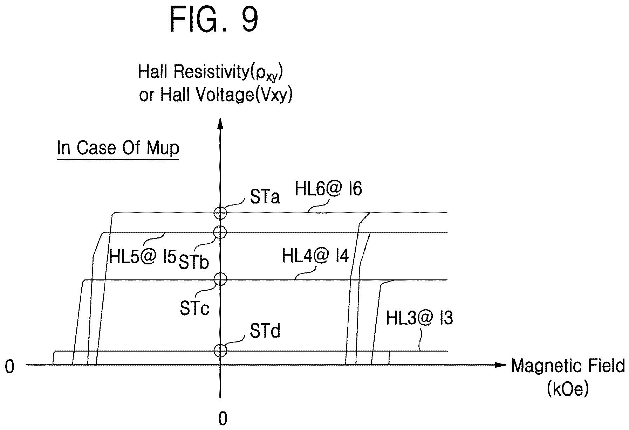

FIG. 9 is a graph showing a change in Hall resistivity or Hall voltage with respect to a change in the value of an input current supplied to the semiconductor device of FIG. 1 when the magnetization direction of the semiconductor device is a first magnetization direction.

Referring to FIGS. 1, 2, 4A, 4B, and 9, when the magnetization direction of the semiconductor device 110 is the first magnetization direction Mup, each of states STd, STc, STb, and STa of the semiconductor device 110 may be respectively determined according to the values of the Hall voltage Vxy, which are respectively determined according to the values (e.g., I3, I4, I5, and I6) of the input current Ix supplied to the semiconductor device 110.

Because the value of the Hall voltage Vxy of the semiconductor device 110 described with reference to FIGS. 1 to 9 is determined according to the value of the input current Ix, the semiconductor device 110 may be in one state among the states STa to STd respectively corresponding to 2-bit values, e.g., 00, 01, 11, and 10.

In addition, because the value of the Hall voltage Vxy of the semiconductor device 110 described with reference to FIGS. 1 to 9 is determined according to a combination of the magnetization direction of the semiconductor device 110 and the value of the input current Ix, the semiconductor device 110 may be used as a memory device storing 2-bit data.

The semiconductor device 110 may include a magnetic tunneling junction (MTJ) including a free magnetization layer. A memory device including the semiconductor device 110 may correspond to magnetic random-access memory (MRAM), spin-transfer torque (STT) MRAM, or spin-orbit torque (SOT) MRAM.

Although I3 and -I1 are both named the third value and I4 and -I3 are both named the fourth value in the descriptions above, this is just for convenience of description.

According to the embodiments of the inventive concept, a semiconductor device, an operating method thereof, and a semiconductor system including the semiconductor device may have an effect of simultaneously changing the polarity and the magnitude of an AHE signal according to a combination of the value of an input current and a magnetization direction. In addition, according to the embodiments of the inventive concept, a semiconductor device, an operating method thereof, and a semiconductor system including the semiconductor device may have an effect of simultaneously changing the polarity and the magnitude of an AHE signal according to the value of an input current.

**Claims**

1. A semiconductor device comprising:

   a free magnetization layer including a ferromagnetic layer; and
   a nonmagnetic metal layer including current electrodes receiving an input current and Hall voltage electrodes outputting a Hall voltage,
   wherein the Hall voltage is generated by an anomalous Hall effect (AHE) occurring in the ferromagnetic layer of the free magnetization layer due to the input current flowing in the nonmagnetic metal layer,
   wherein the Hall voltage has one of a local minimum value and a local maximum value when a value of the input current sequentially changes from a first value to a second value, and
   wherein one of the first value and the second value is greater than the other one of the first value and the second value.

2. The semiconductor device of claim 1, wherein, when the value of the input current sequentially increases from the first value to a threshold current value, the Hall voltage sequentially decreases and has the local minimum value at the threshold current value, and
   wherein when the value of the input current sequentially increases from a value greater than the threshold current value to the second value, the Hall voltage sequentially increases.

3. The semiconductor device of claim 1 or 2, wherein, when the value of the input current sequentially decreases from the first value to a threshold current value, the Hall voltage sequentially increases and has the local maximum value at the threshold current value, and,
   wherein when the value of the input current sequentially decreases from a value less than the threshold current value to the second value, the Hall voltage sequentially decreases.

4. The semiconductor device of any of the claims 1 to 3, wherein, when the value of the input current is the first value and a magnetic field of the free magnetization layer increases, a polarity of the Hall voltage changes from positive to negative, and
   wherein when the value of the input current is the second value and the magnetic field of the free magnetization layer increases, the polarity of the Hall voltage changes from negative to positive.

5. The semiconductor device of any of claims 1 to 4, wherein a magnetization direction of the free magnetization layer is determined to be one of a first magnetization direction and a second magnetization direction according to the value of the input current,

   wherein a polarity of the Hall voltage is one of positive and negative when the magnetization direction is the first magnetization direction,
   wherein the polarity of the Hall voltage is the other one of the positive and the negative when the magnetization direction is the second magnetization direction, and
   wherein the first magnetization direction is opposite to the second magnetization direction.

6. The semiconductor device of any of claims 1 to 5, wherein a magnetization direction of the free magnetization layer is determined to be one of a first magnetization direction and a second magnetization direction according to an external magnetic field of the semiconductor device,

   wherein a polarity of the Hall voltage is one of positive and negative when the magnetization direction is the first magnetization direction,

wherein the polarity of the Hall voltage is the other one of the positive and the negative when the magnetization direction is the second magnetization direction, and

wherein the first magnetization direction is opposite to the second magnetization direction.

7. The semiconductor device of any of claims 1 to 6, wherein the Hall voltage has a first voltage value when the value of the input current is the first value,

wherein the Hall voltage has a second voltage value when the value of the input current is the second value,

wherein the first voltage value corresponds to one state among a plurality of states corresponding to a plurality of bits, and

wherein the second voltage value corresponds to another state among the plurality of states.

8. A semiconductor system comprising:

a semiconductor device including a free magnetization layer including a ferromagnetic layer and a nonmagnetic metal layer including current electrodes and Hall voltage electrodes;

an input current control circuit configured to provide an input current to the current electrodes, the input current being controlled in response to a current control signal; and

a Hall voltage detection circuit connected to the Hall voltage electrodes and configured to detect a Hall voltage generated by an anomalous Hall effect (AHE) occurring in the ferromagnetic layer of the free magnetization layer due to the input current flowing in the nonmagnetic metal layer,

wherein the Hall voltage has one of a local minimum value and a local maximum value when a value of the input current sequentially changes from a first value to a second value, and

wherein one of the first value and the second value is greater than the other one of the first value and the second value.

9. The semiconductor system of claim 8, wherein, when the value of the input current sequentially increases from the first value to a threshold current value, the Hall voltage sequentially decreases and has the local minimum value at the threshold current value, and,

wherein when the value of the input current sequentially increases from a value greater than the threshold current value to the second value, the Hall voltage sequentially increases.

10. The semiconductor system of claim 8 or 9, wherein, when the value of the input current sequentially decreases from the first value to a threshold current value, the Hall voltage sequentially increases and has the local maximum value at the threshold current value, and,

wherein when the value of the input current sequentially decreases from a value less than the threshold current value to the second value, the Hall voltage sequentially decreases.

11. The semiconductor system of any of claims 8 to 10, wherein the semiconductor device further includes a magnetic tunneling junction (MTJ) including the free magnetization layer and corresponds to one of magnetic random-access memory (MRAM), spin-transfer torque (STT) MRAM, and spin-orbit torque (SOT) MRAM.

12. An operating method of a semiconductor device, wherein the semiconductor device including a free magnetization layer including a ferromagnetic layer and a nonmagnetic metal layer, the operating method comprising:

supplying an input current having a first value to the nonmagnetic metal layer;

detecting a first Hall voltage generated by an anomalous Hall effect (AHE) occurring in the ferromagnetic layer due to the input current that flows in the nonmagnetic metal layer and has the first value;

supplying the input current having a second value to the nonmagnetic metal layer; and

detecting a second Hall voltage generated by the anomalous Hall effect (AHE) occurring in the ferromagnetic layer due to the input current that flows in the nonmagnetic metal layer and has the second value.

13. The operating method of claim 12, wherein one of the first Hall voltage and the second Hall voltage has one of a local minimum value and a local maximum value when a value of the input current sequentially changes from the first value to the second value, and

wherein one of the first value and the second value is greater than the other one of the first value and the second value.

14. The operating method of claim 13, wherein, when the value of the input current sequentially increases from the first value to a threshold current value, the one of the first Hall voltage and the second Hall voltage sequentially decreases and has the local minimum value at the threshold current value, and,

wherein when the value of the input current sequentially increases from a value greater than the threshold current value to the second value, the one of the first Hall voltage and the second Hall voltage voltage sequentially increases.

# FIG. 1

# FIG. 2

110_2

|  | B1 | B2 | B3 | B4 |
|---|---|---|---|---|
| 101g | Ta | Ta | Ta | Ta |
| 101f | Pd | Pd | Pd | Pd |
| 101e | R–Co | R–Co | R–Co | R–Co |
|  | ⋮ | ⋮ | ⋮ | ⋮ |
| 101d | Pd | Pd | Pd | Pd |
| 101c | R–Co | R–Co | R–Co | R–Co |
| 101b | Pd | Pd | Pd | Pd |
| 101a | Ta | Ta | Ta | Ta |

115

113   113   113

RP

111

# FIG. 3

Hall Resistivity($\rho_{xy}$)

HL

0

Magnetic Field
(kOe)

0

# FIG. 4A

# FIG. 4B

# FIG. 4C

```
┌─────────────────┐
│       Mup       │∿ S110
└─────────────────┘
         │
         ▼ ◄─────────────────────────┐
┌─────────────────┐                  │
│  Ix INCREASES   │∿ S120            │
└─────────────────┘                  │
         │                           │
         ▼                           │
┌─────────────────┐                  │
│  Vxy DECREASES  │∿ S130            │
└─────────────────┘                  │
         │          S140             │
         ▼                           │
        ╱╲                   NO      │
       ╱    ╲  ───────────────────── ┘
      ╱ Ix >  ╲
      ╲ IHT1 ? ╱
       ╲    ╱
        ╲╱
         │
        YES
         ▼
┌─────────────────┐
│  Vxy INCREASES  │∿ S150
└─────────────────┘
```

# FIG. 4D

```
┌──────────────────┐
│     Mdown        │── S210
└──────────────────┘
         │
         ▼ ◄─────────────────────┐
┌──────────────────┐             │
│  Ix DECREASES    │── S220       │
└──────────────────┘             │
         │                        │
         ▼                        │
┌──────────────────┐             │
│  Vxy INCREASES   │── S230       │
└──────────────────┘             │
         │          S240          │
         ▼                   NO   │
      ╱─────────╲ ───────────────┘
     ╱ Ix < −IHT2 ╲
      ╲─────────╱
         │ YES
         ▼
┌──────────────────┐
│  Vxy DECREASES   │── S250
└──────────────────┘
```

# FIG. 5

Hall Resistivity($\rho_{xy}$)
or Hall Voltage(Vxy)

In Case Of Mup

HL1@ I1

ST1

HL3@ I3

0

ST2

Magnetic Field
(kOe)

0

# FIG. 6

Current (Ix)

I3

I1

T1   T2   T3   T4   T5   T6   T7   Time

−I1

−I3

# FIG. 7

Hall Resistivity($\rho_{xy}$)
or Hall Voltage(Vxy)

Vxy_1(I1, Mup)

Vxy_2(I3, Mup)

Vxy_3(−I3, Mdown)

Vxy_4(−I1, Mdown)

ST1

ST2

ST3

ST4

ST1

T1    T2    T3    T4    T5    T6    T7    Time

# FIG. 8

Hall Resistivity($\rho_{xy}$)
or Hall Voltage(Vxy)

In Case Of Mdown

ST3

0

HL3@ −I3

ST4

HL1@ −I1

Magnetic Field
(kOe)

0

# FIG. 9

Hall Resistivity($\rho_{xy}$)
or Hall Voltage(Vxy)

In Case Of Mup

STa  HL6@ I6

HL5@ I5 STb  HL4@ I4

STc

HL3@ I3

STd

0

Magnetic Field
(kOe)

0

Europäisches
Patentamt
European
Patent Office
Office européen
des brevets

# EUROPEAN SEARCH REPORT

**Application Number**

EP 24 22 2720

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 116 322 278 A (UNIV CHINESE HONG KONG SHENZHEN; UNIV HONG KONG SCIENCE & TECH) 23 June 2023 (2023-06-23) * paragraphs [0002], [0004], [0043], [0044]; claims 1,4; figures 2,4-6; example 3 * | 1-14 | INV. H10B61/00 H10N52/00 ADD. H10N52/85 |
| X | US 2018/366172 A1 (WANG JIAN-PING [US] ET AL) 20 December 2018 (2018-12-20) * paragraphs [0005], [0072]; figures 11A, 11B, 11C * | 1-14 | |

**TECHNICAL FIELDS SEARCHED (IPC)**

H10B
H10N

The present search report has been drawn up for all claims

| Place of search | Date of completion of the search | Examiner |
|---|---|---|
| Munich | 13 May 2025 | Gröger, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 22 2720

This annex lists the patent family members relating to the patent documents cited in the above-mentioned European search report.
The members are as contained in the European Patent Office EDP file on
The European Patent Office is in no way liable for these particulars which are merely given for the purpose of information.

13-05-2025

| Patent document cited in search report | | Publication date | Patent family member(s) | Publication date |
|---|---|---|---|---|
| CN 116322278 | A | 23-06-2023 | NONE | |
| US 2018366172 | A1 | 20-12-2018 | NONE | |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240070873
- KR 1020240100861